# EUROPEAN PATENT SPECIFICATION

(11) **EP 0 447 550 B1**
(45) Date of publication and mention of the grant of the patent: **09.04.1997**
(21) Application number: 90900328.7
(22) Date of filing: 07.12.1989
(51) Int. Cl.: H01G 13/06

(54) **METHOD FOR PRODUCING A METALLIZED FILM FOR LAMINATED CHIP CAPACITORS**
VERFAHREN ZUR HERSTELLUNG EINER METALLISIERTEN FOLIE FÜR CHIPSCHICHTKONDENSATOREN
PROCEDE DE PRODUCTION D'UN FILM METALLISE POUR CONDENSATEURS DE CIRCUITS INTERGRES FEUILLETES

(30) Priority: 07.12.1988 JP 307799/88
(43) Date of publication of application: 25.09.1991
(73) Proprietor: HONSHU PAPER CO., LTD., Chuo-ku Tokyo (JP)
(72) Inventor: YAMAUCHI, Tsunetatsu, Gifu 508 (JP); OKANIWA, Masataka, Gifu 508 (JP); MURATA, Mamoru, Gifu 508 (JP)
(74) Representative: Williams, John Francis
(86) International application number: JP8901229
(87) International publication number: WO9006586

(56) References cited:
- WO-A-87/00208
- CH-A- 265 967
- GB-A- 1 106 364
- JP-A- 165 825
- JP-A- 5 158 649
- JP-A- 6 240 714
- JP-A-57 177 518
- LU-A- 42 919
- PATENT ABSTRACTS OF JAPAN vol. 12, no. 358 (C-531)26 September 1988;& JP-A-63114956

## Description

### Technical Field

This invention relates to metallized films produced by depositing metal on a dielectric film surface, especially for the production of laminated chip capacitors.

### Background of the Technology

Conventional capacitors for which a metallized film is used are winding-type capacitors with terminals, which comprise a capacitor element produced by alternately laminating and winding two metal films which comprise counter electrodes of metals such as zinc or pewter sprayed and welded to both ends of the capacitor element to form electrode output and lead lines.

For the automatic and high speed assembly of capacitors for electrical equipment laminated chip capacitors have become popular in place of winding-type capacitors. The demand for laminated chip capacitors has increased greatly since their square-shape facilitates handling and automation and their high speed assembly.

The use of metallized film for laminated chip capacitors has been recently introduced.

Laminated chip capacitors, a metallized film used therefore and a method of producing the same are disclosed in Japanese patent laid opened Nos. Sho 57-152122. Sho 59-197121, Sho 59-228708. However these prior art devices have inconveniences and an improvement thereof is required.

JP-A-63/114,956 discloses a system for producing a metallised film which includes a covered roll having a raised pattern thereon for depositing a layer of oil onto a film and a cooling roll 7 at which metal is deposited onto the areas of film not covered by oil.

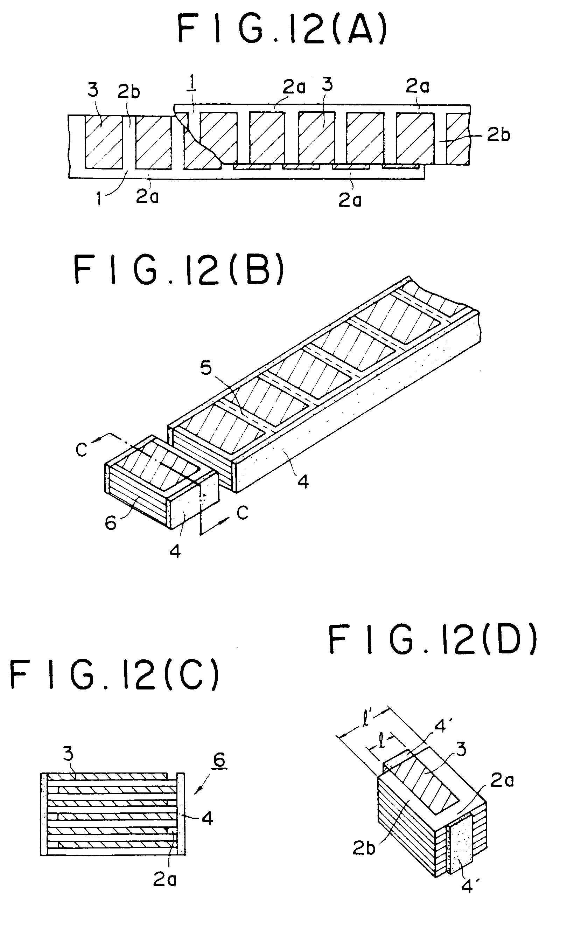

Laminated chip capacitors of conventional prior art form will be briefly described with respect to attached Figs. 12 to 14. In Fig.12A two metallized films are shown ready for laminating. The configuration of metallized film shown in Fig.12A comprises a belt-like dielectric film 1 having a horizontal margin portion 2a along one side of the film and vertical margin portions 2b extending from the margin 2a at right angles thereto. Metal films 3 are independently deposited between the margins 2a,2b. As shown in Figs.12a to 12D, a plurality of such metallized films are laminated with the respective horizontal margin portions 2a thereof facing alternately in opposite directions.

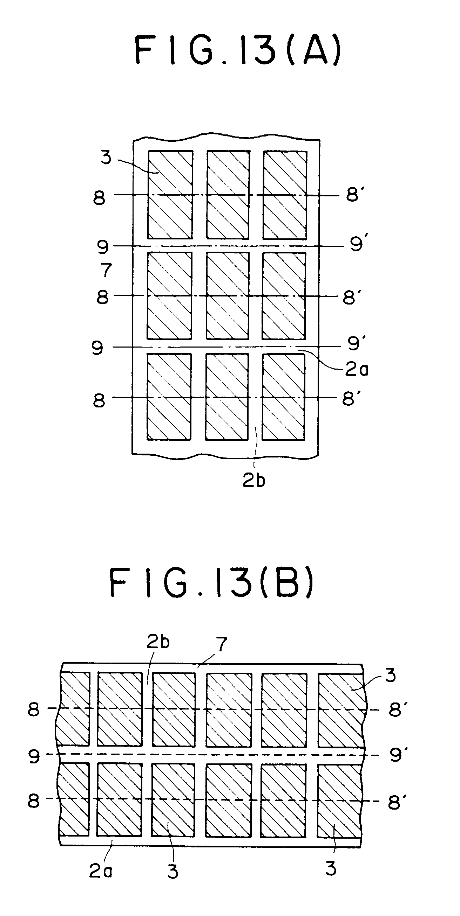

Metal contacts 4,4' are respectively formed at opposite edge portions of the laminate at the exposed surface of each margin portion. A chip capacitor 6 of which an enlarged sectional view is shown in Fig.12C is obtained by cutting the laminate structure of Fig.12B along a centre line 6 of each margin portion 2b as shown in the left end of Fig.12B. To produce a metallized film as described above, as shown in Figs 13A and 13B, metal deposited films 3 are formed on a surface of a dielectric material film 7 in the pattern shown in Fig.13A. The metal deposited film is then cut along the cutting lines indicated by numerals 8,8', 9 and 9'. In a method described above, a basket-type grid masking drum with respect to said margin portion is prepared, a metal evaporating source is disposed therein and margin portions which have a shape corresponding to said grid of the drum is formed on the material film surface for depositing a metal. In the other method, two rotating cylindrical masking rollers in which respective slit is located with respect to each of vertical and horizontal margin portions is used. During said rollers are orderly contacting and rotating with the material film, the material film surface is coated by a masking oil which is evaporated from said roller inside through the slit to permit margin portions corresponding to respective slit width to remain and a metal depositing is practised.

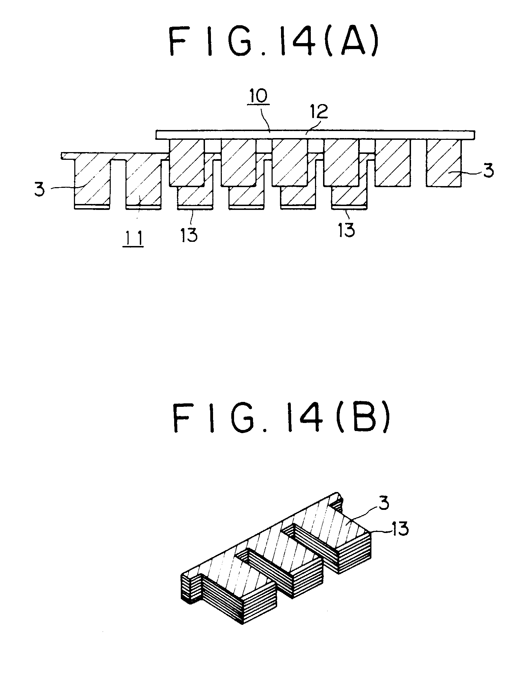

The conventional method of producing the metallized film other than that described above will be briefly described hereinafter with respect to Figs. 14A and 14B. This method uses a masking tape or an electric discharge process or laser. As shown in Fig.14A, two kinds of metallized films are produced including a metallized film 10 having a margin portion 12 which extends the lengthwise direction of the film and a metallized film 11 having an intermittent margin portion 13 at the opposite side to the margin portion 12. A laminated film 14 is obtained by laminating the metallized films 10,11 and metal contacts 4,4 are provided on both edge surfaces.

The problems entailed with metallized films as described above will be described hereinbelow. In the first type of metallized film as shown in Fig.12A margin portions 2a and 2b are provided on three sides surrounding a carpenter's square-shape of deposited metal 3. When spraying metal contacts 4 on the laminated film, the metal is deposited over the whole area of the laminated film surface. However, the metal contact cannot be electrically connected to a film portion which comprises margin portions and portions where the metal is existing are electrically connected therewith, and nothing more. The problem is apparent from consideration of a unit of laminated capacitor element 6 as shown in Fig. 12D. Since the width l of the deposited metal 3 which comprises an electrode is narrower than whole width l of said laminated films 6, when a metal is sprayed on both edge surfaces thereof, as shown in Fig.12B, the metal portion 4 apparently seems to be formed on whole of said edge surfaces. However, this metal portion is electrically deposited only within the width l of the deposited metal as indicated by a numeral 4' of Fig.12D. In using the conventional metallized film as described above, it is impossible to deposit the metal portion over the whole area of the laminated surface, and as a result the tan-δ characteristic and the withstand voltage strength are inferior for a capacitor. The inconvenience described above is also unavoidable with a metallized film having a shape as shown in Fig.14 although the extent of the inconvenience is not the same.

Referring to a method of producing a metallized film, a considerable complicated masking device should be used for forming the margin portion which has a shape as described above in a vacuum depositing apparatus, further, in a conventional method thereof, as already described, it is merely possible to form an approximately carpenter's square-shape metal deposited film maintaining a pattern like as a form of tails being adhered and there has been a problem that complicated pattern such as a skewered pattern of the film can not be formed. Further there is another method of forming margin portions not using a vacuum depositing apparatus but eliminating the deposited film by an electric discharge or a laser beam after the metal has been deposited. However, this method is not economical since it involves two steps.

According to the invention, there is provided a method of producing a metallised film for laminated chip capacitors as specified in claim 1.

To solve the several problems encountered with the prior art as described above, the present invention can provide a metallized film having a novel pattern of deposited metal by novel means for efficiently producing the metallized film. The characteristic pattern of the metal deposited on a belt-like dielectric film surface is laid down in a direction at right angles to the lengthwise direction of the film, as a skewered or backbone pattern formed as repeating units along the lengthwise direction of the film. The metallized film so produced is then cut along lines running between each unit of the pattern and also along the centre line of each unit to form half-units of strip metallized film. An element for use as a chip capacitor is obtained from the half-units so formed by laminating them in alternately opposite facing directions.

The novel method of producing metallized film having the shape as described above is different from the conventional masking system. In accordance with a preferred embodiment, a pattern roll is disposed between the dielectric film and a supply roll for applying a masking oil or an evaporating device for the masking oil and a margin portion corresponding to the pattern formed on said pattern roll surface is formed on the dielectric film surface by a transcription system. For applying said masking oil to the pattern roll, an oil supply device is used comprising a gravure roll which partly dips in an oil tank and an offset roll.

In another method, there is provided a device (which is called an oil pot) to carburet or evaporate the masking oil by means of an electric heater, whereby the carbureted and evaporated masking oil is applied to the offset roll, then transferred to the pattern roll surface and hence to the dielectric film.

After transferring the masking oil in the desired pattern to the dielectric film, a metal is deposited on the unmasked area of dielectric film surface. Thereby the margin portion corresponding to said pattern shape on the pattern roll is formed on said film surface. It is necessary to assemble each of the oil film forming devices as described above in a vacuum depositing apparatus.

The metal deposited on the dielectric film surface has a pattern such as a skewered pattern or a backbone pattern which comprises a continuous linear section or spine disposed at right angles to the lengthwise direction of the film and a plurality of branch-shaped sections extending at right angles from both sides of the spine such that said skewered or backbone pattern includes repeating units spaced along the lengthwise direction of the dielectric film.

A device for applying a masking oil on the dielectric film surface may comprise a three-stage roll system including a gravure roll which draws up the oil, an offset roll such as a rubber roll or a sponge roll (a natural rubber or a synthetic resin system foaming roll) which contacts and rotates with said gravure roll and a pattern roll on which a predetermined pattern is formed by raised portions of the roll surface from which oil is transferred to the dielectric film surface.

It is also possible to use a device combined with an oil pot provided with a heater which carburets or evaporates a masking oil, an offset roll and a patter roll contacting and rotating with said offset roll, as described above.

In an oil transferring device in which a gravure roll is used, it is desirable to roughen the pattern roll surface previously or to form said surface from a porous synthetic resin foam. If the pattern roll surface is formed from engraved rubber it may be roughened by once or twice horizontally or vertically scratching with a sand paper of grade over #500 by JIS Standard.

It is preferable to use a masking oil which is normally used for a vacuum depositing. However, depending on the deposited metal, it is necessary to select the oil by reference to its characteristic vapour pressure or an average molecular weight of said metal. In respect of zinc, for example, it is possible to use a popular silicone oil, while for aluminium, perphloro-alkyl-polyether which has a low vapour pressure is preferable for obtaining a clear margin portion (undeposited portion). The vapour pressure of perfluoroalkyl-polyether is within 10⁻¹ to 10⁻⁷ Torr. If aluminium is used for deposition, it is preferable to use an oil which has the vapour pressure over 10⁻³ Torr. The kind of deposited metal to be used in this invention is not restrictive and one may use zinc, aluminium, tin and gold in special cases.

As the dielectric film, a high polymer film such as polpropylene film, polyester film, polyphenylensulfido film, polyether-ether-ketone film, polycarbonate film, polysulfone film, polyimide film, polystyrene film and polyethylene film may be used.

### Brief Description of Drawings

Fig.1 is a plan view of a part of a metallized film;
Fig.2 is an enlarged plan view of a part of the metallized film of Fig.1 between the lines 5-5;
Fig.3 is a perspective view of the part shown in Fig.2 which has been cut at right angles to the lengthwise direction of the film along the line T-T;
Fig.4 is a perspective view of a series of the cut sections of Fig.3 laminated together in alternately opposite facing directions and bonded to metal contacts welded on both edge surfaces of the laminated film, and shown partially cut away at one end;
Fig.5 is a perspective view of a section of the laminated film structure of Fig.4 along the line U-U of Fig.4;
Fig.6 is an outline sectional view of a vacuum depositing apparatus which is used for producing a metallized film;
Fig.7 is a perspective view of a masking oil transferring device which is disposed in the vacuum depositing apparatus of Fig.6;
Figs, 8 and 9 are a partially enlarged perspective views of a pattern roll which form part of the transferring device of Fig.7;
Fig.10 is an outline sectional view of a vacuum depositing apparatus similar to that of Fig.6 but having a modified form of oil transfer device;
Fig.11 is an enlarged perspective view of the masking oil transferring device disposed in the vacuum depositing apparatus shown by Fig.10; and
Figs. 12 to 14 are explanatory views of the conventional metallized film and the process of producing a laminated chip capacitor by using the same. Fig. 12A is a plan view of the metallized film itself. Fig. 12B is a perspective view of the laminated metallized film to which a metal contact is connected and a unit of the chip capacitor which is obtained from a part of said laminated film. Fig. 12C is an enlarged section view taken along the line C-C of Fig. 12B. Fig. 12D is a perspective view of the chip capacitor. Figs 13A and 13B are plan views of a pattern of metal film deposited on a dielectric film surface. Fig. 14A is also a plan view of a metallized film according to the other conventional method and Fig. 14B is a perspective view of the laminated structure formed from the metallized film of Fig. 14A.

### Best Mode for carrying out the Invention

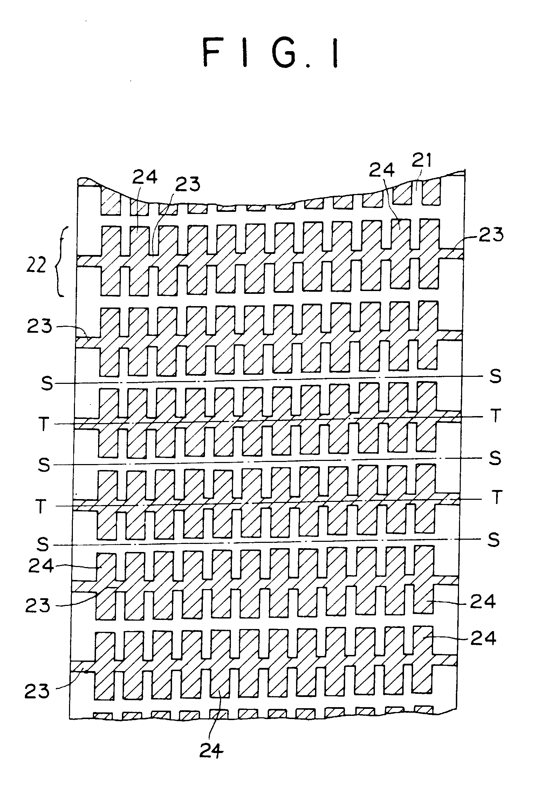

A typical depositing pattern of a metallized film for producing a laminated chip capacitor is shown in Fig.1. A belt-like dielectric film has a metal deposited film in the repeating skewered or backbone pattern indicated by a numeral 22. The skewered pattern or backbone pattern 22 comprises a continuous linear spine 23 disposed at right angles to the lengthwise direction of the film 21 and a plurality of branches 24 extending bilaterally symmetrically from this spine. As shown in Fig.1 the skewered or backbone patterns 22 are repeated and spaced apart along the lengthwise direction of the dielectric film 21.

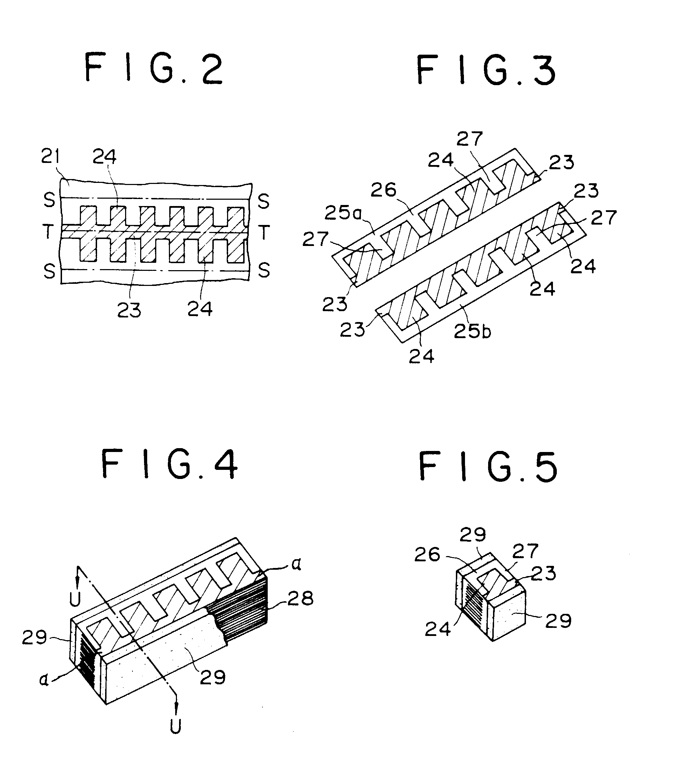

To produce laminated chip capacitors from the metallized film shown in Fig.1, the film 21 is cut along the line SS running between each pattern 22 and the line TT which is the centre line of the spine 23. Fig.2 shows one unit of pattern 22 to be cut along lines SS to TT. Cutting the metallized film as described above produces strip metallized films 25a and 25b which have shapes as shown in Fig.3. The cut position of the spine 23 is disposed along one edge of the film and a continuous horizontal margin portion 26 is formed on the other edge of the film in the lengthwise direction and vertical margin portions 27 are formed between the carpenter's square-shape deposited films 24 which extend from the spine portion 23. The metallized films 25a, 25b are all of identical configuration and a laminated film 28 is produced from them by laminating them in alternately opposite facing directions as shown in Fig.4. A metallic end portion 29 is formed by spraying a metal to both end surfaces thereof to produce the structure of Fig.4. Then the laminated film 28 is cut along the line U-U and a chip-shape capacitor element as shown in Fig.5 is obtained. As indicated by letter a in Fig.4, a linear metal deposited film 23 extends across the whole area of the end surface of the laminated film to permit the area of the metal deposited film to be bigger in comparison with the conventional one and to permit broader metal contacts to be welded on the metal deposited film, and resulting in a chip capacitor which has an excellent tan-characteristic and an excellent withstand voltage characteristic.

Two examples of method of producing a metallized film will be described in detail in accordance with the following examples.

### Example 1

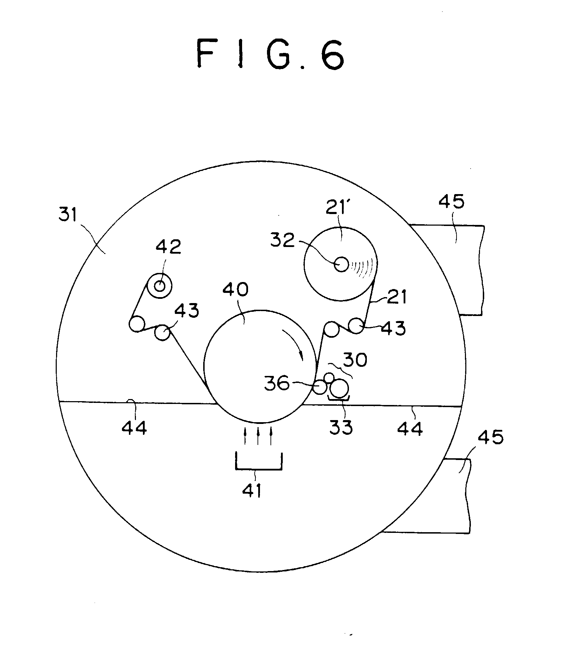

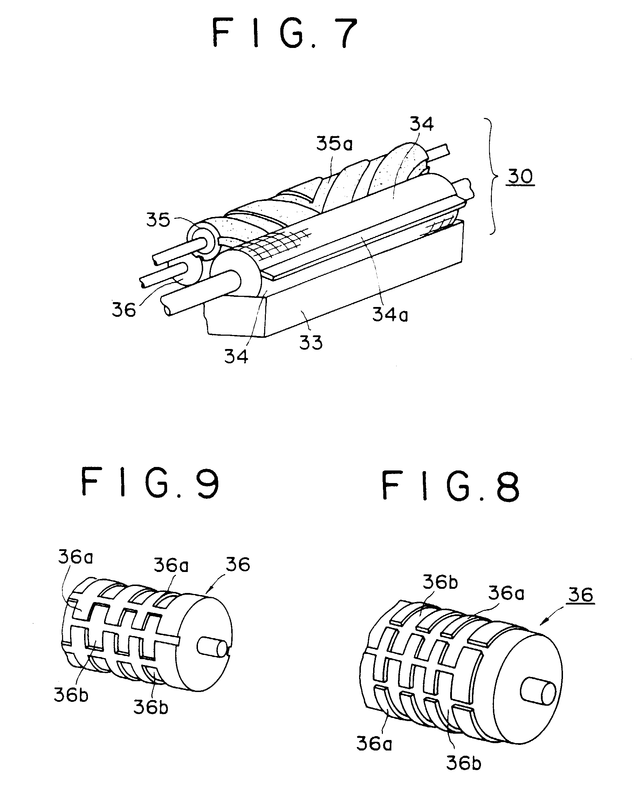

Fig.6 is a side elevation of a vacuum-depositing apparatus containing a device 30 for transferring a masking oil to the dielectric film 21 in a predetermined pattern as described above. A reel of dielectric film 21, e.g. of a biaxial oriented polyether-ether-ketone film which has a thickness 12 µm, is disposed in a vacuum tank 31 at a vacuum of 10⁻² Torr or below and the dielectric film 21 is fed from an unreel 32 through the masking oil transferring device 30. The transferring device 30 is shown in detail in Figs. 7 to 9, in which the numeral 33 indicates a tank of the masking oil, the numeral 34 indicates a gravure roll partially dipping in the tank 33 to draw up the masking oil. The mesh size of the gravure roll surface is preferably from 200 to 600 mesh. The numeral 34a indicates a doctor blade, while numeral 35 indicates an offset roll which contacts and rotates with the gravure roll 34 to transfer the oil drawn up by the gravure roll to a pattern roll 36 which will be described hereinafter. A sponge roll of which the surface is formed with a spiral groove 35a as shown in Figs.7 to 9 is preferably used as the offset roll.

The pattern roll 36 has a surface formed with a pattern comprising raised portions as shown in Figs. 8 and 9. The roll surface may be an engraved rubber sheet engraved with the repeated skewered or backbone pattern. Fig.8 shows the raised face portions 36a of the roll surface which contains the skewered or backbone pattern and Fig.9 shows the roll surface which is formed with the repeated pattern by the recessed face portions 36b. It is possible to select any pattern since said raised portions are relative with each other. The predetermined skewered or backbone repeating pattern is formed on the roll peripheral surface by said raised pattern and said repeating pattern is produced by a graving or other suitable method.

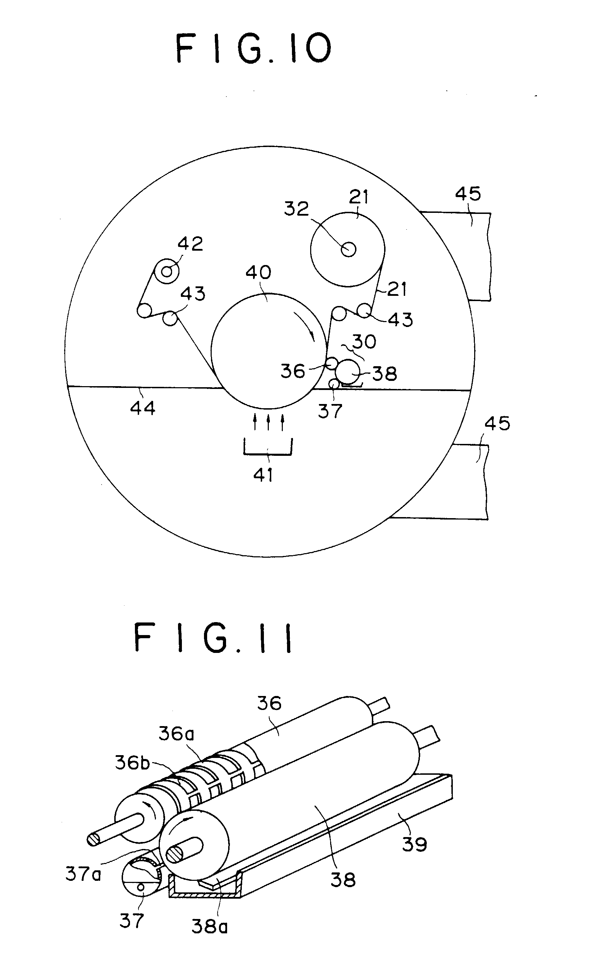

The pattern roll 36 is disposed to contact and rotate with the offset roll 35, and is also attached to contact and rotate with a cooling can 40 in the vacuum-depositing apparatus as shown in Fig.6. The roll 36 and the cooling can 40 engage with the dielectric film 21 which passes between them. As one example of masking oil silicone oil (Trade name. HIVAC F4 manufactured by Shin-etsu Chemical Ind.) is supplied to the tank 33 by the transferring device 30. When the device 30 is operated, the masking oil is drawn up by the gravure roll 34, levelled through the doctor blade 34A and transferred to the pattern roll 36 surface through the intermediary of the offset roll 35. In the embodiment shown in Fig. 10, oil drawn by said gravure roll, for example, is transferred to an offset roll formed of a hard urethane resin foam and then is transferred to the pattern roll which has a rubber surface. As the surface of the pattern roll 36 comprises raised and recessed portions 36a and 36b, only the raised portions contact with the gravure roll 38. Thereby, the masking oil is transferred to only the surface 36a of the pattern roll. Since the pattern roll 36 contacts with the dielectric film 21 after receiving the oil on the raised surface 36a, the oil is transferred to the film 21 surface in a pattern which corresponds to the raised portions 36a of the pattern roll.

The volume of masking oil applied to the pattern roll is adjustable by altering the mesh of the gravure roll. The volume of the oil i.e. film thickness can be reduced by using a roll which has fine meshes and increased by using a coarser mesh. The doctor blade 38a also assists in this process.

The masking oil is thus applied to the dielectric film 21 surface in a pattern corresponding to the non-hatched area shown in Fig.1. Further as shown in Fig.6, the dielectric film 21 to whom the oil film has been applied is then passed over a zinc evaporating source 41 which deposits the metal only on oil-free area thereof. The reason thereof is that the oil reevaporation occurs on the metal evaporating source and a depositing function of the metal atom to the dielectric film is prevented by the oil molecules. The resulting metal deposited film bearing into repeated skewered or backbone pattern is passed over a guide roll 43 and wound by a winding reel 42 shown in Fig.6 to produce an intermediate product for chip capacitors.

In Fig.6 44 indicates a partition wall and 45 an exhaust duct.

In using the intermediate product as described above for the manufacture of chip capacitors, the film is cut in a strip tape-shape along the lines SS, TT in Figs. 1 and 2, and laminated as shown in Fig.s 3 to 5. The metal contact 29 is formed thereon by spraying the metal and the laminated film is cut to obtain the laminated chip capacitors.

Laminated chip capacitors obtained as described above have a withstand voltage of 1000 V and more and a good value of tan-δ characteristic.

In the embodiment described above, when the pattern roll 36 surface is formed from an engraved rubber sheet, the raised surface 36a of the sheet is preferably roughened to absorb the masking oil. For example, the surface may be roughened by scratching it once or twice vertically and horizontally with sand paper (# 500 of JIS standard).

The effect on the degree of oil transfer achieved by the roughening process will be described hereinbelow.

The engraved rubber sheet is mounted on the pattern roll surface, the raised surface is roughened by the sand paper as described below, the oil film is formed by applying a silicone oil (Trade name, HIVAC F4 manufactured by Shin-etsu Chemical Ind.) to the roughened pattern roll surface and oil film is transferred to the polyester film surface. The degree of oil transfer is evaluated by measuring the percentage(%) of the area where the oil transfer has occurred. The result thereof is shown in the following table.

| Roughness No. of sand paper to be used | First Time (%) | Second Time (%) | Third Time (%) |
|---|---|---|---|
| Unprocessed | 0 | 30 | 60 |
| | | | |
| #1200 | 0 | 10 | |
| | | | |
| #1000 | 0 | 10 | 30 |
| | | | |
| # 500 | 0 | 5 | 20 |
| | | | |
| # 240 | 0 | 0 | 20 |
| | | | |
| # 120 | 0 | 0 | 10 |

As shown, more roughening results in more regular oil transfer and it is preferred that the degree of the roughening is #500 and more.

### Example 2

A vacuum depositing apparatus (vacuum 10⁻⁴ Torr) shown in Figs. 10 and 11 is used. Aluminium is used as the depositing metal, perfluoro-alkyl-polyether oil (Trade name S-65 manufactured by Daikin Industries, a vapour pressure thereof is 1 x 10⁻⁴ Torr) is used as a masking oil and a metallized film having a pattern as described in Example 1 is produced. The apparatus shown in Figs. 10 and 11 is the same as described from Fig. 8 except for a modification of the oil transfer device 30. The pattern roll 36 is the same as the one shown in Figs. 8 and 9, and the reference numerals in Figs. 8 and 9 respectively indicate the same elements as in Fig.6.

In Fig.11, the numeral 37 indicates an oil pot provided with a heater for carbureting or evaporating the masking oil. A slit-shape opening portion 37a is formed at the upper portion of the pot 37 and an offset roll 38 is disposed abutting the pot 37. Through the slit-shape opening portion 37a, the vapour of said oil is applied to the offset roll 38 surface from which it is transferred to a pattern roll 36 which contacts and rotates with said offset roll. The surface of said pattern roll 36, comprises the raised and recessed portions 36a, 36b similar to those described in Figs. 8 and 9. As before the oil is transferred only to the raised portion 36a. Therefore the oil film is applied to the film 21 in a repeated pattern corresponding to a pattern provided on the pattern roll surface. A doctor blade 38a in Figs. 10 and 11 is provided for scraping the oil on the offset roll 38 surface. The oil adhering to the recessed portions 36b on the roll 38 is not transferred to the pattern roll and remains thereon, thereby the roll surface is always kept clean.

To adjust the thickness of the masking oil film applied to the dielectric film, it is possible to change the rotating speed (circuit speed) of the offset roll 38. The faster the rotation the thinner the oil film applied and vice versa.

Since the metallized film of the present invention is composed of a repeated pattern in which a distributing condition of the metal deposited film to be formed on the dielectric film surface has a unit of a skewered or backbone pattern-shape, the linear deposited film forming the axis of said pattern-shape and the branch-shape deposited film extending both directions of said linear deposited film are united independently to be metal deposited on the dielectric film surface. Resultantly, for obtaining a metallized film for a laminated chip capacitor, said metallized film is cut to a tape-shape at disconnecting lines which are a centre line of said linear deposited film and a centre line between each abutting branch-shape deposited films. In laminating the film, the counter electrode is obtained by laminating each of films altering each facing direction. The metallized film for a chip capacitor has an excellent effect that it is not necessary to produce metallized film having each different deposited condition for every counter electrodes and it is unnecessary to provide a special process therefore as the conventional method.

Further in case of considering of a unit of capacitors, the metallic portion which is subject to an electrode output is completely deposited electrically through the whole width of the metallized film, thereby a capacitor is so obtained that the metallic portion is prevented from sticking apparently on the margin portion of the dielectric film in different form a conventional method. Thereby the metallized film has an excellent effect of improving not only a withstand voltage characteristic of the chip capacitor of itself but also tan characteristic which determines the quality of this kind of capacitors.

In producing the metallized film having the composition as described hereinbefore, since a very practicable method for industry is developed that it is sufficient only by depositing a metal after transferring a masking oil to the dielectric film surface by a printing system through an intermediary of the transferring device which is substantially composed of the pattern roll having a special pattern-shape, a method has a benefit of easy utility.

### Industrial Applicability of the Invention

The industrial applicability of the present invention is so high that a metallized film sufficiently satisfies the demand of laminated chip capacitors recently increasing in accordance with the progress of the electronics and improves the quality of chip capacitors obtained thereby.

## Claims

1. A method of producing a metallized film for laminated chip capacitors comprising the steps of: providing a pattern roll (36) with raised surface portions (36a) and recessed surface portions (36b), forming a repeating predetermined skewered or backbone pattern (22) of masking oil on a dielectric film surface (21) in the lengthwise direction of said film by means of said pattern roll in a vacuum depositing apparatus; and depositing a metal on the unmasked portion of the dielectric film surface, wherein the masking oil is supplied to the pattern roll (36) through an intermediary both of a gravure roll (34) which partly dips in an oil tank (33) and an offset roll (35) which contacts and rotates with said gravure roll to adjust the sticking volume of the masking oil applied to the pattern roll, said offset roll being formed of a sponge or a hard urethane resin foam.

2. A method according to claim 1, wherein the pattern roll surface is of roughened rubber.

3. A method according to claim 1, wherein the pattern roll surface is composed of a porous synthetic resin foam.

4. A method according to claim 1, wherein a raised surface of the pattern roll is formed with the skewered pattern or the backbone pattern and the masking oil is carbureted or evaporated in a metal depositing apparatus, the carbureted or evaporated oil on the offset roll is transferred to said pattern roll surface and therafter said transferred oil is transferred to the dielectric film.

5. A method according to any preceding claim, wherein the offset roll is designed to adjust the sticking volume.

6. A method according to any preceding claim, comprising the step of adjusting the rotating speed of the offset roll so as to adjust the sticking volume to the masking oil applied to the pattern roll.

7. A method according to any preceding claim, in which perfluoro alkyl-polyether is used as the masking oil.

## Patentansprüche

1. Verfahren zur Herstellung einer metallisierten Folie für Chipschichtkondensatoren, enthaltend die Schritte:
Vorsehen einer mit Mustern versehenen Musterrolle (36) mit erhabenen Oberflächenteilen (36 a) und mit vertieften Oberflächenteilen (36 b), Formen eines längs der Folie sich wiederholenden, vorbestimmten, schrägen oder Rückgrat-Muster (22) aus maskierendem Öl auf einer dielektrischen Oberfläche (21) dieser Folie durch die Musterrolle in einem Vakuumablagerungsapparat; Ablagern eines Metalls auf dem nichtmaskierten Teil der dielektrischen Oberfläche der Folie, bei dem das maskierende Öl vermittels einer zum Teil in einen Öltank (33) tauchenden Gravierungsrolle (34) und einer die Gravierungsrolle berührenden und mit ihr rotierenden Offset-Rolle (35) auf die Musterrolle aufgetragen wird, um das klebende Volumen des der Musterrolle zugeführten maskierenden Öls zu justieren, wobei die Offsetrolle durch einen Schwamm oder einen harten Urethanharzschaum gebildet wird.

2. Verfahren nach Anspruch 1, bei dem die Oberfläche der Musterrolle (36) aus aufgerauhtem Gummi besteht.

3. Verfahren nach Anspruch 1, bei dem die Oberfläche der Musterrolle (36) aus porösem synthetischem Harzschaum zusammengesetzt ist.

4. Verfahren nach Anspruch 1, bei dem eine erhabene Oberfläche derr Musterrolle durch die schrägen oder Rückgrat-Muster gebildet und das maskierende Öl in einem Metallablagerungsapparat karburiert oder verdampft wird, und bei dem das karburierte oder verdampfte Öl der Offsetrolle auf die Oberfläche der Musterrolle übertragen und danach das übertragene Öl auf den dielektrischen Film übertragen wird.

5. Verfahren nach einem der vorhergehenden Ansprüche, wobei die Offsetrolle für die Justierung des klebenden Volumens bemessen ist.

6. Verfahren nach einem der vorhergehenden Ansprüche, bei dem die Drehzahl der Offsetrolle eingestellt wird, um den Auftrag des klebenden Volumens des maskierenden Öls auf die Musterrolle zu justieren.

7. Verfahren nach einem der vorhergehenden Ansprüche, bei dem Perfluoralkylpolyether als maskierendes Öl benutzt wird.

## Revendications

1. Procédé de production d'un film métallisé pour capacités de circuits intégrés feuilletés, comprenant les étapes suivantes : on utilise un rouleau d'application de motif (36) présentant des parties de surface surélevées (36a) et des parties de surface évidées, on forme un motif répétitif prédéterminé, en forme de brochette ou d'arête, (22) d'huile de masquage sur une surface de film diélectrique (21) dans la direction longitudinale dudit film à l'aide dudit rouleau d'application de motif dans un appareil de dépôt sous vide, et on dépose un métal sur la partie non masquée de la surface du film diélectrique, l'huile de masquage étant délivrée au rouleau d'application de motif (36) par l'intermédiaire à la fois d'un rouleau héliographique (34) qui trempe partiellement dans un réservoir d'huile (33) et d'un rouleau offset (35) qui vient en contact et tourne avec ledit rouleau héliographique pour ajuster le volume d'accrochage de l'huile de masquage appliquée au rouleau d'application de motif, ledit rouleau offset étant formé d'une éponge ou d'une mousse de résine uréthanne dure.

2. Procédé selon la revendication 1, dans lequel la surface du rouleau d'application de motif est constituée de caoutchouc rugueux.

3. Procédé selon la revendication 1, dans lequel la surface du rouleau d'application de motif est composée d'une mousse de résine synthétique poreuse.

4. Procédé selon la revendication 1, dans lequel une surface surélevée du rouleau d'application de motif est formée par le motif en forme de brochette ou d'arête et l'huile de masquage est soumise à une carburation ou à une évaporation dans un appareil de dépôt de métal, l'huile carburée ou évaporée sur le rouleau offset est transférée à ladite surface du rouleau d'application de motif et, ensuite, ladite huile transférée est transférée au film diélectrique.

5. Procédé selon l'une quelconque des revendications précédentes, dans lequel le rouleau offset est conçu pour ajuster le volume d'accrochage.

6. Procédé selon l'une quelconque des revendication précédentes, comprenant l'étape d'ajustement de la vitesse de rotation du rouleau offset de manière à ajuster le volume d'accrochage à l'huile de masquage appliquée au rouleau d'application de motif

7. Procédé selon l'une quelconque des revendications précédentes, dans lequel on utilise comme huile de masquage du perfluoro alkyl-polyéther.
